# EUROPÄISCHE PATENTSCHRIFT

(11) **EP 1 304 019 B1**
(45) Veröffentlichungstag und Bekanntmachung des Hinweises auf die Patenterteilung: **14.06.2006**
(21) Anmeldenummer: 01984081.8
(22) Anmeldetag: 22.06.2001
(51) Int. Cl.: H05B 33/08, H01L 25/16

(54) **BELEUCHTUNGSVORRICHTUNG MIT LICHTEMITTIERENDEN DIODEN (LED), BELEUCHTUNGSVERFAHREN UND VERFAHREN ZUR BILDAUFZEICHNUNG MIT DERARTIGER LED-BELEUCHTUNGSVORRICHTUNG**
ILLUMINATING DEVICE WITH LIGHT EMITTING DIODES (LED), METHOD OF ILLUMINATION AND METHOD FOR IMAGE RECORDING WITH SAID LED ILLUMINATION DEVICE
DISPOSITIF D'ECLAIRAGE A DIODES ELECTROLUMINESCENTES (LED), PROCEDE D'ECLAIRAGE ET PROCEDE DE RECONSTITUTION D'IMAGE AU MOYEN DUDIT DISPOSITIF D'ECLAIRAGE A LED

(30) Priorität: 27.06.2000 DE 10031303
(43) Veröffentlichungstag der Anmeldung: 23.04.2003
(73) Patentinhaber: ARNOLD & RICHTER CINE TECHNIK GMBH & CO. BETRIEBS KG, 80799 München (DE)
(72) Erfinder: EBERL, Heinrich, Alexander, 87463 Probstried (DE)
(74) Vertreter: Ninnemann, Detlef
(86) Internationale Anmeldenummer: PCT/DE2001/002349
(87) Internationale Veröffentlichungsnummer: WO 2002/001921

(56) Entgegenhaltungen:
- EP-A- 0 516 398
- EP-A- 0 952 387
- EP-A- 0 966 183
- EP-A- 1 077 444
- EP-A- 1 113 709
- WO-A-98/49872
- WO-A-99/56303
- DE-A- 3 917 101
- DE-A- 19 942 177
- DE-U- 29 607 270

## Beschreibung

Die Erfindung betrifft eine Beleuchtungsvorrichtung mit lichtemittierenden Dioden (LED) nach dem Oberbegriff des Anspruchs 1.

Im Vergleich zu einer Lichtquelle, bei der das Licht durch einen glühenden Körper beispielsweise eine dünne Drahtwendel erzeugt wird, hat eine LED eine Reihe von Vorteilen, wie einen besseren Wirkungsgrad, geringere Abwärmeleistung, höhere mechanischer Stabilität und längere Lebensdauer. Zu Beginn der technologischen Entwicklung wiesen LEDs allerdings vergleichsweise geringe Lichtleistungen auf. Insbesondere die Entwicklung leistungsstarker LEDs im kurzwelligen sichtbaren Spektralbereich des Lichtes erwies sich als problematisch. Daher war die Erzeugung vergleichsweise leistungsstarken Weißlichtes durch additive Farbmischung des Lichtes mindestens dreier LEDs, die eine rote, eine grüne und eine blaue Emissionswellenlänge aufweisen bzw. durch ein genügend breites sichtbares LED-Emissionsspektrum einer einzelnen LED nicht möglich. Aus diesen Gründen kamen LEDs für Beleuchtungszwecke, bei denen Weißlicht benötigt wird, lange Zeit nicht zum Einsatz.

Inzwischen ist es möglich, LEDs mit Emissionswellenlängen in allen Bereichen des sichtbaren Lichtspektrums mit Lichtleistungen herzustellen, die den Anforderungen einer Vielzahl konventioneller Glühwendel-Beleuchtungseinrichtungen gerecht werden. Der Einsatz eines LED-Beleuchtungseinrichtungen ist daher oftmals nur noch eine Preisfrage.

Aus der DE 39 17 101 A1 ist eine konventionelle Glühwendel-Beleuchtungsanlage bekannt, die die Mischung unterschiedlicher Farbtöne und -intensitäten des abgestrahlen Lichtes erlaubt.

Die WO99/31560 offenbart eine große Zahl von Vorrichtungen und Verfahren, bei denen jeweils LEDs als Lichtquellen zum Einsatz kommen. LED-Beleuchtungsvorrichtungen sind zum Beispiel in der WO 97/48134, WO 98/40665 und der WO 99/30537 offenbart. Insbesondere in der WO 98/40665 und der WO 99/30537 werden Vorrichtungen beschrieben, bei denen das Licht durch eine Vielzahl auf einem flächigen Träger angeordneter LED-Leuchtpixel erzeugt wird. Jeder Leuchtpixel umfaßt drei LEDs: eine LED mit einer Emissionswellenlängen im roten, eine im grünen und eine im blauen Spektralbereich. Durch die steuerbare additive Farbmischung des roten, grünen und blauen LED-Lichts kann die LED-Beleuchtungsvorrichtung Licht jeder gewünschten Farbtemperatur abstrahlen.

Durch Degeneration des LED-Materials, insbesondere der licht-emittierenden Schichten, ändern sich jedoch mit der Zeit Intensität und Wellenlänge des emittierten LED-Lichtes. Dies führt trotz konstant gehaltenen LED-Strömen dazu, daß das Licht der LED-Beleuchtungseinrichtung ebenfalls veränderte Intensität und Farbtemperatur aufweist. Die bekannten LED-Beleuchtungsvorrichtungen weisen den Nachteil auf, daß eine derartige Änderung von Farbemperatur und Intensität des Lichtes der LED-Beleuchtungsvorrichtung hingenommen werden muß. Gerade in professionellen Anwendungsbereichen Ist aber die Verläßlichkeit, daß die Beleuchtungsvorrichtung Licht der gewünschten Farbtemperatur und Intensität abstrahlt von entscheidender Bedeutung.

Der Erfindung liegt daher die Aufgabe zu Grunde, eine Beleuchtungsvorrichtung mit lichtemittierenden Dioden (LED) bereitzustellen, die Licht einer Vielzahl vorgegebener Farbtemperatur- und Intensitätsparameter abstrahlen kann, wobei die Farbtemperatur und Intentsitätsparameter des abgestrahlten Lichtes mit hoher Verläßlichkeit während der gesamten Lebensdauer der Vorrichtung den vorgegebenen Farbtemperatur- und Intensitätsparametern entsprechen sollen.

Die Aufgabe wird erfindungsgemäß durch eine Vorrichtung mit den Merkmalen des Anspruchs 1 gelöst.

Danach weist die Beleuchtungsvorrichtung ein LED-Trägerelement auf, das sowohl als plane als auch als gekrümmte Fläche ausgeformt werden kann. Auf dem LED-Trägerelement sind eine Vielzahl lichtemittierender Leuchtpixel beispielsweise matrixartig angeordnet. Diese Leuchtpixel umfassen jeweils eine Mehrzahl LEDs mit Emissionswellenlängen, die zur additiven Farbmischung des vom Leuchtpixel emittierten Lichtes geeignet sind. Um sämtliche Farbtöne des sichtbaren Lichtspektrums darstellen zu können, ist die Kombination dreier LEDs mit Emissionswellenlängen im roten, im grünen und im blauen Bereich des sichtbaren Lichtspektrums notwendig.

Für ein farbechtes Erscheinen beleuchteter Gegenstände ist es jedoch weiterhin notwendig, daß die spektralen Emissionsbandbreiten der rot, grün und blau emittierenden LED den gesamten sichtbaren Spektralbereich abdecken. Besteht eine spektrale Lücke zwischen den Emissionsbandbreiten zweier LEDs, so kann zwar ein Farbton, der in dieser spektralen Lücke liegt, durch die entsprechende Mischung roten, grünen und blauen Lichts generiert werden; bei der Beleuchtung eines Gegenstandes, der eben diesen Farbton aufweist, kommt es allerdings hinsichtlich des vom Gegenstand reflektierten Lichtes zwangsläufig zu Farbfehlern. Dieser Effekt liegt darin begründet, daß der beleuchtete Gegenstand für das Licht der verschiedenen Wellenlängen unterschiedliche Reflexionskoeffizienten aufweist, so daß sich in Reflexion durch das veränderte Mischungsverhältnis der unterschiedlichen Lichtanteile ein verfälschter Farbton resultiert. Um diesen Effekt zu kompensieren, kann beispielsweise in jedem Leuchtpixel zusätzlich zu den LEDs mit Emissionswellenlängen in roten, grünen und blauen Spektralbereich eine breitbandig emittierende Weißlicht-LED eingesetzt werden.

Weiterhin weist die Beleuchtungsvorrichtung eine Ansteuervorrichtung auf, mit der sich für das additiv farbgemischte Licht jedes einzelnen Leuchtpixels ein Farbtemperaturparameter und ein Intensitätsparameter vorgeben lassen. Die Ansteuervorrichtung ordnet diesen vorgegebenen Parametern entsprechende LED-Ströme zu und steuert die LEDs der Leuchtpixel mit den zugeordneten LED-Strömen an.

Die Beleuchtungsvorrichtung umfaßt Regelungsmittel, die die Farbtemperatur und Intensität des Lichtes mindestens eines Leuchtpixels messen, die gemessenen Farbtemperatur- und Intensitätsparameter mit den entsprechend vorgegebenen Parametern vergleichen und bei Abweichungen der gemessenen Parameter von den vorgegebenen Parametern das emittierte Licht des Leuchtpixels mittels der Ansteuervorrichtung derart stabilisieren, daß die gemessenen Parameter mit den vorgegebenen Parametern übereinstimmen.

In einer vorteilhaften Ausführungsform umfassen die Regelungsmittel eine Halbleitersensoreinheit, die zur Messung der jeweiligen roten grünen und blauen Spektralanteile des Lichtes der Leuchtpixel geeignet ist. Aus dem Verhältnis und dem Betrag der jeweiligen spektralen Meßwerte lassen sich Farbtemperatur- und Intensitätsparameter des abgestrahlten Lichtes bestimmen. Die der Halbleitersensoreinheit zugeordnete Vergleichs- und Regeleinheit vergleicht die gemessenen mit den vorgegebenen Farbtemperatur- und Intensitätsparametern. Weichen die Parameter voneinander ab, so veranlaßt die Vergleichs- und Regeleinheit, daß die Ansteuervorrichtung des LED-Trägerelementes die LED-Ströme derart nachregelt, daß keine Unterschiede mehr zwischen gemessenen und vorgegebenen Farbtemperatur- und Helligkeitsparametern bestehen.

Es ist weiterhin von Vorteil, die Regelungsmittel räumlich vom LED-Trägerelement zu beabstanden, damit beispielsweise die Abwärme des LED-Trägerelementes nicht zu einer Verfälschung der Meßwerte der Halbleitersensoreinheit führen. Bei einer derartigen Beabstandung muß das Licht des Leuchtpixels der entfernt angeordneten Halbleitersensoreinheit zugeführt werden. Dies erfolgt geeigneterweise mit Hilfe eines Lichtleiters, beispielsweise in Form einer optischen Glas- oder Kunststofffaser oder eines integriert optischen Lichtwellenleiters.

Einerseits ist es möglich, den Lichtleiter an einen einzelnen Leuchtpixel zu koppeln, der dann als Referenzlichtquelle benutzt wird, andererseits ist eine Messung des emittierten Lichtes jedes einzelnen Leuchtpixels wünschenswert. Zu diesem Zweck ist es von vorteilhaft, den Lichtleiter in einer solchen Ring- bzw. Schleifenform am LED-Trägerelement anzuordnen, daß Anteile des emittierten Lichtes jedes einzelnen Leuchtpixels in den Lichtleiter einkoppeln können.

Insbesondere bei Verwendung einer Glas- bzw. Plastikfaser als Lichtleiter kann die Faser im Bereich des LED-Trägerelementes so geformt und angeordnet werden, daß Licht, das aus Richtung der Leuchtpixel einfällt, in den Lichtleiter einkoppeln kann, während beispielsweise Fremd- und Umgebungslicht, das aus anderen Richtungen kommend auf den Lichtleiter trifft, nur zu einem sehr geringen Teil in den Lichtleiter einkoppelt.

Zur aktiven Steuerung der Farbtemperatur- und Intensitätsparameter jedes einzelnen Leuchtpixels ist es notwendig, aus dem Gemisch des Lichtes aller Leuchtpixel jeweils das Licht einzelner Leuchtpixel zu extrahieren. Dies geschieht am einfachsten, indem man die Lichtsignale der Leuchtpixel im Zeitmultiplex auswertet. Dazu steuert man die einzelnen LEDs der Leuchtpixel geeigneterweise mit LED-Strömen an, die im MHz-Bereich getaktet sind. Kalkuliert man beispielsweise pro Leuchtpixel zur aktiv geregelten Erzeugung einer Anzahl von Lichtpulsen, die ein ausreichendes Detektorsignal liefern, ein Zeitfenster von 10µs, so können innerhalb von 1ms 100 Leuchtpixel hintereinander aktiv geregelt angesteuert werden. Daraus resultiert eine Beleuchtungsfrequenz von 1kHz, so daß störende Schwebungseffekte beispielsweise bei der Aufnahme einer beleuchteten Szene mit einer Laufbildkamera erst bei entsprechend hohen Laufbildfrequenzen auftreten können.

Zum Zweck der einfachen Handhabbarkeit ist es von Vorteil, das LED-Trägerelement und in einem Scheinwerfergehäuse anzuordnen.

Weiterhin kann dem Scheinwerfergehäuse eine Beobachtungskamera zur Abbildung einer mit dem Scheinwerfer beleuchteten Szene zugeordnet sein. Die Beobachtungskamera ist entweder innerhalb oder außerhalb des Scheinwerfergehäuses angeordnet und fest mit dem Scheinwerfergehäuse verbunden.

Es ist von Vorteil, als Beobachtungskamera eine Halbleiter-Kamera (CCD, CMOS) einzusetzen. Diese kann sehr klein ausgebildet sein, was dessen platzsparende Anordnung innerhalb des Scheinwerfergehäuses ermöglicht.

In einer weiteren Ausführungsform weist die Ansteuerungsvorrichtung ein Bedienungsterminal mit einem Bildschirm auf. Dieser Bildschirm erlaubt eine bequeme Benutzerführung der Beleuchtungsvorrichtung und kann darüber hinaus das mittels der Beobachtungskamera aufgezeichnete Bild der beleuchteten Szene darstellen.

Mit Hilfe der auf dem LED-Trägerelement angeordneten Leuchtpixel ist es bei allen Ausführungsformen der Beleuchtungsvorrichtung möglich, mit Hilfe der Ansteuervorrichtung beliebige zweidimensionale Farbverlaufs- und Intensitätsprofile des von der Beleuchtungsvorrichtung emittierten Lichtes auf einfache Weise nachzubilden. Dazu müssen die LEDs der Leuchtpixel jeweils mit den entsprechenden Strömen angesteuert werden. Im Vergleich dazu ist bei Anwendung eines konventionellen Glühlampen-Scheinwerfers für jedes Farbverlaufs- und Intensitätsprofil ein individuelles Filterelement notwendig. Bei einem Einsatz der Beleuchtungsvorrichtung sind derartige Filterelemente überflüssig.

Bei einer Beleuchtungsvorrichtung mit Beobachtungskamera besteht zusätzlich die Möglichkeit, die Beleuchtung einer Szene aktiv zu kontrollieren und zu steuern. Dazu läßt sich die zu beleuchtende Szene mittels der Beobachtungskamera auf dem Bildschirm der Ansteuerungsvorrichtung darstellen. Der Nutzer legt dann anhand dieses Bildes die gewünschten Beleuchtungsbedingungen der zu beleuchtenden Szene fest. Daraufhin ermittelt die Ansteuervorrichtung das zugehörige Farbverlaufs- und Intensitätsprofil und steuert die LEDs des LED-Trägerelementes mit den entsprechenden Strömen an. Das Bild der beleuchteten Szene wird anschließend mit der Beobachtungskamera aufgezeichnet, die Ansteuerungsvorrichtung wertet es aus und vergleicht es mit den vom Nutzer gewünschten Beleuchtungsbedingungen. Treten dabei beispielsweise aus Gründen besonderer Reflexionseigenschaften der beleuchteten Szene Abweichungen auf, so regelt die Ansteuerungsvorrichtung die LED-Ströme nach, bis die vom Nutzer gewünschten Beleuchtungsbedingungen eingestellt sind.

Ein weiteres vorteilhaftes Arbeitsverfahren besteht in der Nutzung der erfindungsgemäßen Beleuchtungsvorrichtung bei der Aufzeichnung von Bildern eines bewegten Körpers mit einer Kamera. Die Beleuchtungsvorrichtung stellt dabei Beleuchtungslicht für den Körper zur Verfügung, der sich vor einem Hintergrund bewegt, der relativ zur Kamera ruht. Während oder zwischen der Aufzeichnung der einzelnen Bilder des bewegten Körpers mit der Kamera wird die Farbtemperatur des Beleuchtungslichtes verändert. Dabei ist die Änderung der Farbtemperatur des Beleuchtungslichtes als Funktion der Zeit vorgebbar. Dadurch ist in jedem Bild des bewegten Körpers die Information über die bereits abgelaufene Bewegungszeit anhand der Farbe codiert, in der der bewegte Körper abgebildet ist.

Je mehr Farbtemperaturen das Beleuchtungslicht während der Aufnahme eines einzelnen Bildes aufweist, desto farbloser, d.h. grau bzw. weiß, erscheint der Hintergrund, vor dem sich der bewegte Körper in den verschiedenen Farbtemperaturen an unterschiedlichen Bildpositionen deutlich abzeichnet.

Um diesen Effekt zu optimieren, ist es notwendig, daß das Beleuchtungslicht während der Aufzeichnungszeit zwischen einem Startzeitpunkt und einem Endzeitpunkt sämtliche sichtbaren Spektralfarben aufweist. Es ist vorteilhaft, die Farbtemperatur des Beleuchtungslichtes während der Aufzeichnungszeit schrittweise oder kontinuierlich vom violetten zum roten Bereich des Spektrums hin zu verändern, weil auf diese Weise die Bewegungszeit durch die bekannte Farbfolge des Weißlichtspektrums codiert ist. Die umgekehrte Richtung, vom roten zum violetten Spektralbereich, stellt aus dem genannten Grund ebenfalls eine vorteilhafte Möglichkeit zur Änderung der Farbtemperatur des Beleuchtungslichtes dar.

Wird die Farbtemperatur zwischen der Aufnahme einzelner Bilder verändert, so ist eine nachträgliche Überlagerung der Einzelbilder notwendig, um den gleichen Darstellungseffekt zu erhalten. Für eine solche Bild-Nachbearbeitung ist es vorteilhaft, wenn die verwendete Kamera digitale Bildsignale liefert, so daß die nachträgliche Überlagerung mit Hilfe eines Computers mit entsprechender Software durchgeführt werden kann.

Die Zeitauflösung bei der Darstellung der Bewegung des Körpers ergibt sich aus dem Quotienten der Aufzeichnungszeit durch die Zahl der möglichen Farbtemperaturen des Beleuchtungslichtes. Die Zeitauflösung läßt sich jedoch noch erheblich steigern, indem die Beleuchtung des Körpers mit einer zeitlich definierten Abfolge sämtlicher erzeugbarer Farbtemperaturen in periodischen Abständen wiederholt wird. Dadurch liegt die theoretisch erreichbare Zeitauflösung in der Zeitkonstante, die die Beleuchtungsvorrichtung benötigt, zwischen zwei Farbtemperaturen umzuschalten. Den begrenzenden Faktor wird in der Praxis allerdings die minimale Bildaufnahmezeit darstellen, die die Kamera benötigt, um den mit Licht der jeweiligen Farbtemperatur beleuchteten Körper "farbecht" abbilden zu können.

Bei einer gleichförmigen Bewegung des Körpers ist es vorteilhaft, die Farbtemperatur proportional mit der Bewegungszeit zu ändern.

Werden Bilder einer räumlich und zeitlich periodischen Körperbewegung mit einer Periodizitätszeit T aufgenommen, so ist es von Vorteil, wenn die Aufzeichnungszeit der halben Periodizitätszeit T/2 entspricht, um die Überlagerung der Hin- und Rückbewegung des Körpers bei der Darstellung zu vermeiden. Insbesondere bei sehr kleinen Periodizitätszeiten T beleuchtet man den Körper geeigneterweise während einer Vielzahl hintereinander erfolgender Hin- oder Rückbewegungen der Dauer T/2 mit Licht identischer Farbcodierung. Auf diese Weise wird die Bewegung des Körpers in einer Art Stroboskopbetrieb der Beleuchtungsvorrichtung abgebildet.

Mehrere Ausführungsbeispiele der Beleuchtungsvorrichtung werden anhand der nachfolgenden Figuren beschrieben. Es zeigen:
- Fig. 1 -: eine schematische Darstellung der Beleuchtungsvorrichtung;
- Fig. 2 -: eine erste mögliche Ausführungsform der Vorrichtung aus Fig. 1;
- Fig. 3 -: eine weitere mögliche Ausführungsform der Beleuchtungsvorrichtung und
- Fig. 4 -: einen Längsschnitt durch einen mögliche Ausführungsform eines Scheinwerfers der Beleuchtungsvorrichtung.

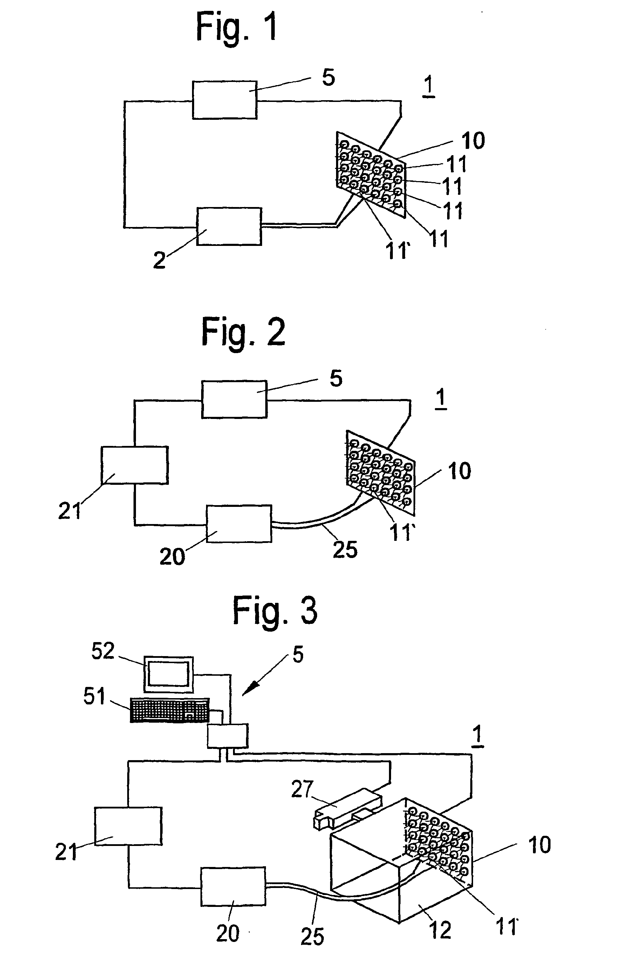

In Fig. 1 ist die erfindungsgemäße Beleuchtungsvorrichtung 1 schematisch dargestellt. Das LED-Trägerelement 10 ist als plane oder gekrümmte Fläche ausgebildet und weist auf seiner Oberfläche eine Vielzahl von Leuchtpixeln 11 auf. Diese Leuchtpixel 11 sind in dichtem Abstand angeordnet und bilden eine auf dem LED-Trägerelement 10 eine Leuchtfläche aus. Das flächige LED-Trägerelement 10 kann beliebige geometrische Formen aufweisen. Runde bzw. rechteckige Leuchtflächen lassen sich am einfachsten auf entsprechend runden bzw. rechteckigen LED-Trägerelementen 10 realisieren.

Jeder Leuchtpixel 11 umfaßt mindestens drei LEDs. Die erste LED weist eine rote, die zweite eine grüne und die dritte eine blaue Emissionswellenlänge auf, wobei die Emissionswellenlängen zur additiven Farbmischung sämtlicher Farbtemperaturen des sichtbaren Lichtes geeignet sind und die Emissionsbandbreiten der drei LEDs den gesamten sichtbaren Spektralbereich abdecken. Wenn sich spektrale Lücken zwischen den Emissionsbandbreiten der drei LEDs ergeben, ist die Verwendung einer zusätzlichen weißen LED notwendig, deren breites Emissionsspektrum die Lücke zwischen den farbigen LEDs schließt.

Die LEDs der Leuchtpixel werden mittels einer Ansteuerungsvorrichtung 5 mit elektrischem Strom versorgt. Der LED-Betrieb erfolgt mit Strompulsen, so daß durch eine Modulation der Pulsweite die Intensität des emittierten LED-Lichtes beeinflußt werden kann. Auf diese Weise lassen sich die Mischungsverhältnisse der drei Farbanteile des additiv gemischten LED-Lichtes und somit die resultierende Farbtemperatur jedes einzelnen Leuchtpixels 11 ansteuern. Vorgegebenen Parametern für Farbtemperatur und Intensität der Leuchtpixel ordnet die Ansteuerungsvorrichtung 5 die entsprechenden LED-Ströme zu und steuert die LEDs mit den zugeordneten Strömen an.

Die Regelungsmittel 2 messen Farbtemperatur und Intensität des emittierten Lichtes mindestens eines Leuchtpixels 11' des LED-Trägerelementes 10, vergleichen die gemessenen Parameter mit den durch die Ansteuervorrichtung 5 vorgegebenen Parametern für Farbtemperatur und Intensität und veranlassen die Ansteuerungsvorrichtung 5, die LED-Ströme nachzuregeln, bis die gemessenen Parameter den vorgegebenen Parametern entsprechen.

Fig. 2 zeigt eine mögliche Ausführungsform der schematisch in Fig. 1 dargestellten Beleuchtungsvorrichtung 1. Ein Halbleitersensoreinheit 20 mißt die Farbtemperatur und Intensität des Lichtes mindestens eines Leuchtpixels 11' des LED-Trägerelements 10, das mittels eines Lichtleiters 25 vom LED-Trägerelement 10 zur Halbleitersensoreinheit 20 geführt wird. Als Lichtleiter 25 können sowohl optische Glas- als auch Plastikfasern benutzt werden. Vorteilhaft ist auch der Einsatz eines integriert optischen Lichtleiter-Detektorsystems. Dabei handelt es sich um ein Bauelement, bei dem Lichtleiter und Detektor auf einem gemeinsamen Substrat in Halbleiter-Dünnschichttechnologie hergestellt werden. Durch die Verwendung eines solchen Bauteiles entfällt die aufwendige optische Kopplung eines separaten Lichtleiters an die Halbleitersensoreinheit bei der Montage der Beleuchtungsvorrichtung 1.

Es ist vorteilhaft, wenn die Halbleitersensoreinheit 20 drei Einzeldetektoren aufweist, von denen der erste das Signal des roten, der zweite das Signal des grünen und der dritte das Signal des blauen LED-Lichtes Lichtes erzeugt. Diese Meßvorrichtung läßt sich auf einfache Weise durch den Einsatz entsprechender Transmissionsfilter vor den jeweiligen Einzeldetektoren realisieren.

Die Vergleichs- und Regeleinheit 21 vergleicht die vom Halbleitersensoreinheit 20 gemessenen Farbtemperatur- und Intensitätsparameter mit den durch die Ansteuerungsvorrichtung 5 vorgegebenen Farbtemperatur- und Intensitätsparametern. Bei einem Abweichen veranlaßt die Vergleichs- und Regeleinheit 21 die Ansteuervorrichtung 5, die LED-Ströme nachzuregeln, bis die gemessenen Parameter mit den vorgegebenen übereinstimmen.

Mit den durch die Leuchtpixel 11 auf dem LED-Trägerelement 10 ausgebildeten Leuchtflächen ist es möglich, beliebige Farbverlaufs- und Intensitätsprofile zu realisieren. Als Intensitätsprofil kann zum Beispiel das Gauß-förmige Profil eines konventionellen Glühlampenscheinwerfers simuliert werden.

Durch die Halbleitersensoreinheit 20 und die Vergleichs-und Regeleinheit 21 wird dabei gewährleistet, daß die Farbtemperatur- und Intensitätsparameter des abgestrahlten Lichtes der Leuchtpixel 11' mit hoher Verläßlichkeit während der gesamten Lebensdauer der Beleuchtungsvorrichtung 1 den mit der Ansteuerungsvorrichtung 5 vorgegebenen Farbtemperatur- und Intensitätsparametern entsprechen.

Die in Fig. 3 dargestellte Ausführungsform der Beleuchtungsvorrichtung 1 entspricht weitgehend der in Fig. 2 dargestellten Vorrichtung. Für gleiche Bauelemente werden daher gleiche Bezugszeichen verwendet.

Das LED-Trägerelement 10 ist in einem Scheinwerfergehäuse 12 angeordnet. Dem Scheinwerfergehäuse ist eine Beobachtungskamera 27 zugeordnet. Die Beobachtungskamera 27 ist mit der Ansteuerungsvorrichtung 5 verbunden und bildet eine mit der Beleuchtungseinrichtung zu beleuchtende Szene auf dem Bildschirm 52 der Ansteuerungsvorrichtung 5 ab. Außerdem weist die Ansteuerungsvorrichtung 5 Eingabemittel 51, beispielsweise eine Computertastatur mit einer Maus auf. Dadurch wird eine bequeme Bedienung der Beleuchtungsanlage 1 durch einen Nutzer ermöglicht.

Damit das Scheinwerfergehäuse 12 leicht zu handhaben ist, bietet es sich an, die Beobachtungskamera 27 als Miniatur-CCD-Kamera auszulegen, so daß sie problemlos im Inneren des Scheinwerfergehäuses 12 befestigt werden kann.

Die dargestellte Ausführungsform der Beleuchtungsvorrichtung 1 bietet die Möglichkeit, daß ein Benutzer mit Hilfe der auf dem Bildschirm 52 abgebildeten zu beleuchtenden Szene über die Eingabemittel 51 gewünschte Beleuchtungsbedingungen der Szene vorgibt. Die Ansteuerungsvorrichtung 5 ermittelt daraufhin die entsprechenden LED-Ströme und steuert die Leuchtpixel 11 des LED-Trägerelementes 10 entsprechend an.

Die nun beleuchtete Szene wird wiederum mittels der Beobachtungskamera 27 auf dem Bildschirm 52 dargestellt, woraufhin die Ansteuerungsvorrichtung 5 durch eine geeignetes Softwareprogramm die Unterschiede zwischen den vom Nutzer gewünschten und den durch die Beobachtungskamera 27 abgebildeten Beleuchtungsbedingungen auswertet. Daraufhin kann entweder manuell durch den Nutzer oder automatisch durch ein Softwareprogramm der Ansteuerungsvorrichtung 5 die Stromansteuerung der Leuchtpixel 11 nachgeregelt werden, bis die gewünschten Beleuchtungsbedingungen erreicht sind.

Bei Verwendung einer optischen Faser als Lichtleiter 25 ist es möglich, die Halbleitersensoreinheit 20 und die Vergleichs- und Regeleinheit 21 mit in das Gehäuse der Ansteuerungsvorrichtung 5 zu integrieren. Dadurch ergibt sich eine einzige kompakte Geräteeinheit, die lediglich über ein elektrisches Kabel und den Lichtleiter 25 mit dem Scheinwerfergehäuse 12 verbunden werden muß.

Weiterhin kann die Ansteuerungsvorrichtung 5 Schnittstellen aufweisen, die eine Vernetzung und zentrale Steuerung einer Vielzahl von Beleuchtungsvorrichtungen 1 ermöglicht.

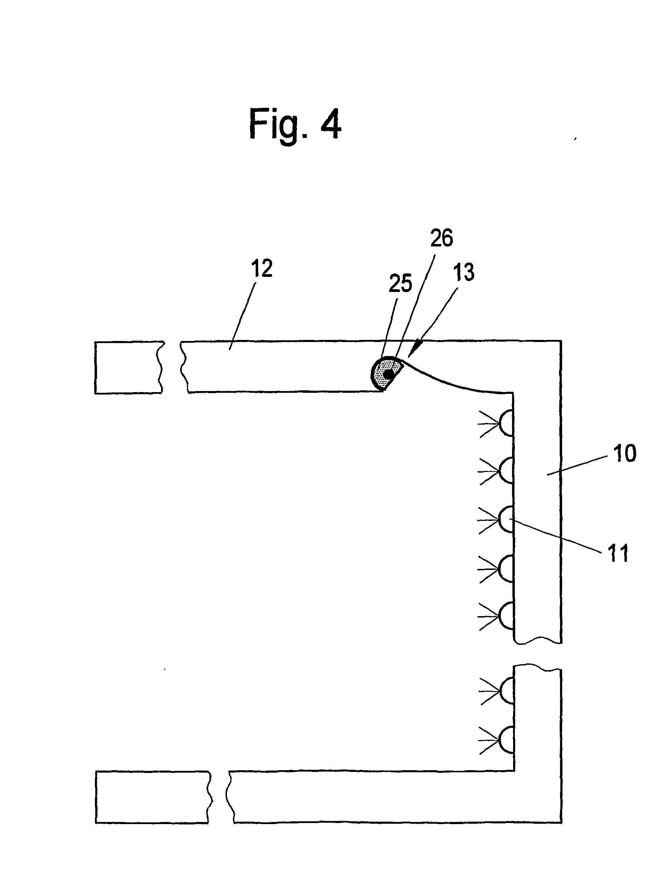

Figur 4 zeigt eine vorteilhafte Anordnung von Lichtleiter 25 und LED-Trägerelement 10 in einem Scheinwerfergehäuse 12. Dabei verläuft der im Scheinwerfergehäuse 12 angeordnete Endabschnitt des Lichtleiters 25 in einem im Scheinwerfergehäuse 12 kehlförmig ausgebildeten Abschnitt 13 im wesentlichen parallel zum LED-Trägerelement 10. Die Öffnung dieses kehlförmig ausgebildeten Abschnittes 13 zeigt dabei in Richtung des LED-Trägerelementes 10, so daß ein Anteil des Lichtes jedes Leuchtpixels 11 auf den Lichtleiter trifft, aber kein störendes Umgebungslicht, das direkt in das Scheinwerfergehäuse 12 fällt, in den Lichtleiter 25 einkoppeln kann.

Der im kehlförmig ausgebildeten Abschnitt 13 angeordnete Bereich des Lichtleiters 25 ist derart aufgebaut, daß die lichtführende Schicht 26 eine Grenzfläche zur Luft innerhalb des Scheinwerfergehäuses 12 aufweist. Dies läßt sich beispielsweise durch das Anschleifen einer Glasfaser längs ihrer Erstreckungsrichtung realisieren. Dadurch wird sichergestellt, daß ein ausreichender Anteil des Lichts der Leuchtpixel 11 in den Lichtleiter 25 einkoppelt und zur Detektoreinheit 20 gelangt.

## Patentansprüche

1. Beleuchtungsvorrichtung mit lichtemittierenden Dioden (LED) mit
- einem LED-Trägerelement, auf dem eine Vielzahl von Leuchtpixeln angeordnet sind, die Licht emittieren, wobei die Leuchtpixel jeweils eine Mehrzahl von LEDs umfassen, die unterschiedliche, zur additiven Farbmischung des Lichts der Leuchtpixel geeignete Emissionswellenlängen aufweisen, und
- einer dem LED-Trägerelement zugeordneten Ansteuervorrichtung, mit der sich dem additiv.farbgemischten Licht jedes einzelnen Leuchtpixels ein Farbtemperatur-und ein - Intensitätsparameter vorgeben lassen, wobei die Ansteuervorrichtung den vorgegebenen Farbtemperatur- und Intensitätsparametern entsprechende elektrische LED-Ströme zuordnet und die LEDs der Leuchtpixel mit den zugeordneten LED-Strömen ansteuert,
**dadurch gekennzeichnet,**
**daß** die Beleuchtungsvorrichtung (1) Regelungsmittel (2) aufweist, die Farbtemperatur und Intensität des emittierten Lichtes mindestens eines Leuchtpixels (11') des LED-Trägerelementes (10) messen, die gemessenen Farbtemperatur- und Intensitätsparameter mit den vorgegebenen Farbtemperatur-und Intensitätsparametern des Leuchtpixels (11') vergleichen und bei Abweichungen der gemessenen Farbtemperatur-und/oder Intensitätsparameter von den vorgegebenen Farbtemperatur- und Intensitätsparametern das emittierte Licht des Leuchtpixels (11') mittels der Ansteuervorrichtung (5) derart stabilisieren, daß das emittierte Licht des Leuchtpixels (11') die vorgegebenen Farbtemperatur- und Intensitätsparameter aufweist.

2. Beleuchtungsvorrichtung nach Anspruch 1, **dadurch gekennzeichnet, daß** die Regelungsmittel (2) eine Halbleitersensoreinheit (20) für das von den Leuchtpixeln (11) emittierte Licht und eine der Halbleitersensoreinheit (20) zugeordnete mikroprozessorgesteuerte Vergleichs- und Regeleinheit (21) umfassen.

3. Beleuchtungsvorrichtung nach Anspruch 2, **dadurch gekennzeichnet, daß** an dem LED-Trägerelement (10) mindestens ein Lichtleiter (25) angeordnet ist, der emittiertes Licht mindestens eines Leuchtpixels (11') zu der von dem LED-Trägerelement (10) beabstandet angeordneten Halbleitersensoreinheit (20) führt.

4. Beleuchtungsvorrichtung nach Anspruch 3, **dadurch gekennzeichnet, daß** der Lichtleiter (25) schleifen- oder ringförmig am LED-Trägerelement (10) angeordnet ist, so daß Anteile des emittierten Lichtes sämtlicher Leuchtpixel (11) in den Lichtleiter (25) einkoppeln.

5. Beleuchtungsvorrichtung nach Anspruch 4, **dadurch gekennzeichnet, daß** der Lichtleiter (25) als Glas- oder Plastikfaser ausgebildet ist und im Bereich des LED-Trägerelementes (10) derart geformt ist, daß lediglich Licht, das aus der Richtung der Leuchtpixel (11) auf den Lichtleiter (25) trifft, in diesen einkoppelt.

6. Beleuchtungsvorrichtung nach einem der vorangehenden Ansprüche, **dadurch gekennzeichnet, daß** die Ansteuervorrichtung (5) die einzelnen LEDs der Leuchtpixel (11) mit Strompulsen ansteuert, die im MHz-Bereich getaktet sind.

7. Beleuchtungsvorrichtung nach einem der vorangehenden Ansprüche, **dadurch gekennzeichnet, daß** das LED-Trägerelement (10) in einem Scheinwerfergehäuse (12) angeordnet ist.

8. Beleuchtungsvorrichtung nach Anspruch 7, **dadurch gekennzeichnet, daß** ein Abschnitt des Lichtleiters (25) im Scheinwerfergehäuse (12) im wesentlichen parallel zum LED-Trägerelement (10) verläuft und daß dieser Abschnitt des Lichtleiters (25) so ausgebildet ist, daß Licht der Leuchtpixel (11) in den Lichtleiter (25) einkoppeln kann.

9. Beleuchtungsvorrichtung nach Anspruch 8, **dadurch gekennzeichnet, daß** der Abschnitt des Lichtleiters (25) in einem kehlförmig ausgeformten Abschnitt (13) des Scheinwerfergehäuses (12) angeordnet ist und daß die Öffnungsrichtung des kehlförmig ausgeformte Abschnitt (13) so auf das LED-Trägerelement (10) hin ausgerichtet ist, daß kein direkt in das Scheinwerfergehäuse (12) einfallendes Umgebungslicht in den Lichtleiter (25) einkoppeln kann.

10. Beleuchtungsvorrichtung nach Anspruch 9, **dadurch gekennzeichnet, daß** dem Scheinwerfergehäuse (12) und der Ansteuervorrichtung (5) eine Beobachtungskamera (27) zugeordnet ist, die eine mit der Beleuchtungsvorrichtung (1) beleuchtete Szene abbildet und daß die Beobachtungskamera (27) entweder innerhalb oder außerhalb des Scheinwerfergehäuses (12) fest mit diesem verbunden ist.

11. Beleuchtungsvorrichtung nach Anspruch 10, **dadurch gekennzeichnet, daß** die Beobachtungskamera (12) als CCD-oder CMOS-Kamera ausgebildet ist.

12. Beleuchtungsvorrichtung nach einem der vorangehenden Ansprüche, **dadurch gekennzeichnet, daß** die Ansteuerungsvorrichtung (5) einen Bildschirm (52) und Dateneingabemittel (51) aufweist.

13. Verwendung einer Beleuchtungsvorrichtung nach einem der vorangehenden Ansprüche in einem Beleuchtungsverfahren,
**dadurch gekennzeichnet,**
**daß** die Farb- und Intensitätsparameter des von den einzelnen Leuchtpixeln (11) emittierten Lichtes derart angesteuert werden, daß zweidimensionale Farbverlaufsprofile und/oder Intensitätsprofile des Lichtes konventioneller Glühwendel-Scheinwerfer mittels der Leuchtpixel (11) des LED-Trägerelementes (10) nachgebildet werden.

14. Verwendung einer Beleuchturigsvorrichtung nach Anspruch 12 in einem Verfahren zur Beleuchtung einer Szene,
**gekennzeichnet durch** die folgenden Arbeitsschritte:
- Darstellung der **durch** die Beobachtungskamera (27) abgebildeten zu beleuchtenden Szene auf dem Bildschirm (52) der Ansteuerungsvorrichtung (5),
- Vorgabe gewünschter Beleuchtungsbedingungen der zu beleuchtenden Szene **durch** Dateneingabemittel (51) der Ansteuerungsvorrichtung (5),
- Ermittlung und Ansteuerung eines den gewünschten Beleuchtungsbedingungen entsprechenden Farbverlaufs-und Intensitätsprofils des vom LED-Trägerelement (10) abgestrahlten Lichtes mittels der Ansteuerungsvorrichtung (5),
- Darstellung und Auswertung des mit der Beobachtungskamera (27) aufgenommenen Bildes der beleuchteten Szene mit Hilfe der Ansteuerungsvorrichtung (5),
- Durchführen einer Korrektur des zweidimensionalen Farbverlaufs- und Intensitätsprofiles des vom LED-Trägerelement (10) abgestrahlten Lichtes mittels der Ansteuerungsvorrichtung (5) bis die beleuchtete Szene die gewünschten Beleuchtungsverhältnisse aufweist.

15. Verwendung einer Beleuchtungsvorrichtung gemäß einem der Ansprüche 1 bis 12 in einem Verfahren zur Aufzeichnung von Bildern einer Bewegung mindestens eines Körpers vor einem Hintergrund, mit folgenden Verfahrensschritten
- Bereitstellung von Beleuchtungslicht für die Beleuchtung des Körpers mittels der Beleuchtungsvorrichtung und
- Aufzeichnen von Bildern der Bewegung des Körpers vor dem Hintergrund mit einer Kamera,
wobei die Kamera bei der Aufzeichnung der Bilder relativ zum Hintergrund ruht,
**dadurch gekennzeichnet,**
**daß** während oder zwischen der Aufzeichnung der Bilder Farbtemperatur und/oder Intensität des Beleuchtungslichtes der Beleuchtungsvorrichtung (1) verändert wird.

16. Verwendung nach Anspruch 15, wobei die Bewegung des Körpers während einer Aufzeichnungszeit zwischen einem Anfangszeitpunkt und einem Endzeitpunkt aufgezeichnet wird, **dadurch gekennzeichnet, daß** das Beleuchtungslicht zum Anfangszeitpunkt eine Anfangsfarbtemperatur im violetten Spektralbereich, zum Endzeitpunkt eine Endfarbtemperatur im roten Spektralbereich und während der Aufzeichnungszeit eine Vielzahl von Farbtemperaturen zwischen dem roten und violetten Spektralbereich des Farbspektrums aufweist.

17. Verwendung nach Anspruch 15, wobei die Bewegung des Körpers während einer Aufzeichnungszeit zwischen einem Anfangszeitpunkt und einem Endzeitpunkt aufgezeichnet wird, **dadurch gekennzeichnet, daß** das Beleuchtungslicht zum Anfangszeitpunkt eine Anfangsfarbtemperatur im roten Spektralbereich, zum Endzeitpunkt eine Endfarbtemperatur im violetten Spektralbereich und während der Aufzeichnungszeit eine Vielzahl von Farbtemperaturen zwischen dem roten und violetten Spektralbereich des Farbspektrums aufweist.

18. Verwendung nach Anspruch 16 oder 17, **dadurch gekennzeichnet, daß** die Farbtemperatur des Beleuchtungslichtes zwischen dem Anfangs- und dem Endzeitpunkt der Aufzeichnung der Bilder schrittweise oder kontinuierlich von der Anfangsfarbtemperatur zur Endfarbtemperatur verändert wird.

19. Verwendung nach Anspruch 18, **dadurch gekennzeichnet, daß** die Farbtemperatur des Beleuchtungslichtes proportional mit der Aufzeichnungszeit verändert wird.

20. Verwendung nach einem der Ansprüche 15 bis 19, wobei der Körper eine zeitlich und räumlich periodische Bewegung mit einer Periodizitätszeit T ausführt, **dadurch gekennzeichnet, daß** die Aufzeichnungszeit zwischen Anfangs-und Endzeitpunkt der halben Periodizitätszeit T/2 entspricht.

21. Verwendung nach einem der Ansprüche 15 bis 20, **dadurch gekennzeichnet, daß** als Kamera eine Video-, CCD- oder CMOS-Kamera eingesetzt wird.

22. Verwendung nach Anspruch 21, **dadurch gekennzeichnet, daß** eine Vielzahl von Einzelbildern, die während der Aufzeichnungszeit aufgezeichnet wurden, mit Mitteln der digitalen Bildverarbeitung in einem einzigen Bild überlagert dargestellt werden.

## Claims

1. Illumination device with light emitting diodes (LEDs) with
- an LED support element, on which a large number of light pixels that emit light are arranged, whereby the light pixels include in each case a plurality of LEDs that have different emission wavelengths suitable for the additive color mixing of the light of the light pixels, and
- a controller associated with the LED support element, with which a color temperature parameter and an intensity parameter can be pre-set for the additively color mixed light of each individual light pixel, whereby the controller assigns electrical LED currents corresponding to the pre-set color temperature and intensity parameters and controls the LEDs of the light pixels with the LED currents assigned,
**characterized in**
**that** the illumination device (1) has regulation means (2) that measure the color temperature and intensity of the emitted light of at least one light pixel (11') of the LED support element (10), compare the measured color temperature and intensity parameters with the pre-set color temperature and intensity parameters of the light pixels (11'), and, in the event of deviations of the measured color temperature and/or intensity parameters from the pre-set color temperature and intensity parameters, stabilize the emitted light of the light pixel (11') by means of the controller (5) such that the emitted light of the light pixel (11') has the pre-set color temperature and intensity parameters.

2. Illumination device according to claim 1, **characterized in that** the regulation means (2) include a semiconductor sensor unit (20) for the light emitted by the light pixels (11) and a microprocessor-controlled comparison and regulating unit (21) associated with the semiconductor sensor unit (20).

3. Illumination device according to claim 2, **characterized in that** at least one light guide (25) is arranged on the LED support element (10), which light guide guides the emitted light of at least one light pixel (11') to the semiconductor sensor unit (20) arranged at a distance from the LED support element (10).

4. Illumination device according to claim 3, **characterized in that** the light guide (25) is arranged in a loop or ring shape on the LED support element (10) such that portions of the light emitted by all light pixels (11) are coupled into the light guide (25).

5. Illumination device according to claim 4, **characterized in that** the light guide (25) is designed as a glass or plastic fiber and is shaped in the region of the LED support element (10) such that only light that strikes the light guide (25) from the direction of the light pixels (11) is coupled into it.

6. Illumination device according to one of the preceding claims, **characterized in that** the controller (5) controls the individual LEDs of the light pixels (11) with current pulses that are timed in the MHz range.

7. Illumination device according to one of the preceding claims, **characterized in that** the LED support element (10) is arranged in a spotlight housing (12).

8. Illumination device according to claim 7, **characterized in that** a section of the light guide (25) runs out in the spotlight housing (12) substantially parallel to the LED support element (10) and that this section of the light guide (25) is designed such that light of the light pixels (11) can be coupled into the light guide (25).

9. Illumination device according to claim 8, **characterized in that** the section of the light guide (25) is arranged in a throat-like shaped section (13) of the spotlight housing (12) and that the opening direction of the throat-like shaped section (13) is aimed at the LED support element (10) such that no ambient light falling directly into the spotlight housing (12) can be coupled into the light guide (25).

10. Illumination device according to claim 9, **characterized in that** a viewing camera (27) is associated with the spotlight housing (12) and the controller (5), which camera images a scene illuminated with the illumination device (1), and that the viewing camera (27) is fixedly attached to the spotlight housing (12), either inside or outside it.

11. Illumination device according to claim 10, **characterized in that** the viewing camera (12) is designed as a CCD or CMOS camera.

12. Illumination device according to one of the preceding claims, **characterized in that** the controller (5) has a screen (52) and data input means (51).

13. Use of an illumination device according to one of the previous claims,
**characterized in**
**that** the color and intensity parameters of the light emitted by the individual light pixels (11) are controlled such that two-dimensional color progression profiles and/or intensity profiles of the light of conventional incandescent spotlights can be simulated by means of the light pixels (11) of the LED support element (10).

14. Use of an illumination device according to claim 12 for illumination of a scene,
**characterized by** the following process steps:
- display of the scene to be illuminated imaged by the viewing camera (27) on the screen (52) of the controller (5),
- pre-setting of desired illumination conditions of the scene to be illuminated via data input means (51) of the controller (5),
- determination and control of one of the color progression and intensity profiles of the light emitted by the LED support element (10) corresponding to the desired illumination conditions by means of the controller (5),
- display and evaluation of the image of the illuminated scene recorded with the viewing camera (27) by means of the controller (5),
- execution of a correction of the two-dimensional color progression and intensity profiles of the light emitted by the LED support element (10) by means of the controller (5) until the scene illuminated has the desired illumination relationships.

15. Use of an illumination device according to one of claims 1 through 12 in a method for recording images of a movement of at least one body in front of a background, with following steps
- provision of illumination light for the illumination of the body using the illumination device and
- recording images of the movement of the body in front of the background with a camera
whereby the camera is stationary relative to the background during the recording of the images,
**characterized in**
**that** during or between the recording of the images color temperature and/or intensity of the illumination light of the illumination device (1) is changed.

16. Use according to claim 15, whereby the movement of the body is recorded during a recording period between a starting time point and an end time point, **characterized in that** the illumination light has a beginning color temperature in the violet spectral range at the starting time point and an ending color temperature in the red spectral range at the end time point, and has a large number of color temperatures between the red and violet spectral range of the color spectrum during the recording period.

17. Use according to claim 15, whereby the movement of the body is recorded during a recording period between a starting time point and an end time point, **characterized in that** the illumination light has a beginning color temperature in the red spectral range at the starting time point, an ending color temperature in the violet spectral range at the end time point, and a large number of color temperatures between the red and violet spectral range of the color spectrum during the recording period.

18. Use according to claim 16 or 17, **characterized in that** the color temperature of the illumination light is changed stepwise or continuously between the starting time point and the end time point of the recording of the images from the beginning color temperature to the ending color temperature.

19. Use according to claim 18, **characterized in that** the color temperature of the illumination light is changed in proportion to the recording time.

20. Use according to one of claims 15 through 19, whereby the body carries out a temporally and spatially periodic movement with a periodicity time T, **characterized in that** the recording time between the starting time point and the end time point corresponds to one-half the periodicity time T/2.

21. Use according to one of claims 15 through 20, **characterized in that** a video, CCD, or CMOS camera is used as the camera.

22. Use according to claim 21, **characterized in that** a large number of individual images that were recorded during the recording period are presented overlapped in a single image using digital image processing means.

## Revendications

1. Dispositif d'éclairage à diodes électroluminescentes (DEL), comportant
- un élément porte-DEL sur lequel sont agencés une multitude de pixels luminescents qui émettent de la lumière, les pixels luminescents comprenant chacun une pluralité de DEL qui présentent différentes longueurs d'ondes d'émission appropriées au mélange additif des couleurs de la lumière des pixels luminescents, et
- un dispositif de pilotage associé à l'élément porte-DEL, qui permet d'imposer un paramètre de température de couleur et un paramètre d'intensité à la lumière à mélange additif des couleurs de chaque pixel luminescent individuel, le dispositif de pilotage associant des courants DEL électriques correspondant aux paramètres imposés de température de couleur et d'intensité et pilotant les DEL des pixels luminescents avec les courants DEL associés,
**caractérisé en ce que**
le dispositif d'éclairage (1) comprend des moyens de régulation (2) qui mesurent la température de couleur et l'intensité de la lumière émise d'au moins un pixel luminescent (11') de l'élément porte-DEL (10), qui comparent les paramètres mesurés de température de couleur et d'intensité aux paramètres imposés de température de couleur et d'intensité du pixel luminescent (11'), et qui, en cas d'écart entre les paramètres mesurés de température de couleur et/ou d'intensité et les paramètres imposés de température de couleur et d'intensité, stabilisent au moyen du dispositif de pilotage (5) la lumière émise du pixel luminescent (11'), de telle sorte que la lumière émise du pixel luminescent (11') présente les paramètres imposés de température de couleur et d'intensité.

2. Dispositif d'éclairage selon la revendication 1, **caractérisé en ce que** les moyens de régulation (2) comprennent un ensemble détecteur à semi-conducteur (20) pour la lumière émise par les pixels luminescents (11) et un ensemble de comparaison et de régulation (21) commandé par microprocesseur et associé à l'ensemble détecteur à semi-conducteur (20).

3. Dispositif d'éclairage selon la revendication 2, **caractérisé en ce que** sur l'élément porte-DEL (10) est agencé au moins un guide de lumière (25) qui mène la lumière émise d'au moins un pixel luminescent (11') vers l'ensemble détecteur à semi-conducteur (20) agencé à distance de l'élément porte-DEL (10).

4. Dispositif d'éclairage selon la revendication 3, **caractérisé en ce que** le guide de lumière (25) est agencé en forme de boucle ou d'anneau sur l'élément porte-DEL (10), de sorte que les parts de la lumière émise de tous les pixels luminescents (11) sont injectées dans le guide de lumière (25).

5. Dispositif d'éclairage selon la revendication 4, **caractérisé en ce que** le guide de lumière (25) est réalisé sous forme de fibre de verre ou de matière synthétique et est ainsi formé dans la zone de l'élément porte-DEL (10) que seule la lumière tombant sur le guide de lumière (25) depuis la direction des pixels luminescents (11) est injectée dans celui-ci.

6. Dispositif d'éclairage selon l'une des revendications précédentes, **caractérisé en ce que** le dispositif de pilotage (5) pilote les DEL individuelles des pixels luminescents (11) par des impulsions de courant qui sont cadencées dans la gamme des MHz.

7. Dispositif d'éclairage selon l'une des revendications précédentes, **caractérisé en ce que** l'élément porteur DEL (10) est agencé dans un boîtier de projecteur (12).

8. Dispositif d'éclairage selon la revendication 7, **caractérisé en ce qu'**un tronçon du guide de lumière (25) dans le boîtier de projecteur (12) s'étend sensiblement parallèlement à l'élément porte-DEL (10), et **en ce que** ce tronçon du guide de lumière (25) est réalisé de telle sorte que la lumière des pixels luminescents (11) peut s'injecter dans le guide de lumière (25).

9. Dispositif d'éclairage selon la revendication 8, **caractérisé en ce que** le tronçon du guide de lumière (25) est agencé dans une portion (13) conformée en forme de rainure du boîtier de projecteur (12) et **en ce que** la direction d'ouverture de la portion (13) conformée en forme de rainure est orientée vers l'élément porte-DEL (10) de telle sorte qu'aucune lumière ambiante incidente directement dans le boîtier de projecteur (12) ne peut s'injecter dans le guide de lumière (25).

10. Dispositif d'éclairage selon la revendication 9, **caractérisé en ce qu'**une caméra d'observation (27) est associée au boîtier de projecteur (12) et au dispositif de pilotage (5), qui forme l'image d'une scène éclairée par le dispositif d'éclairage (1), et **en ce que** la caméra d'observation (27) est fermement reliée au boîtier de projecteur (12) soit à l'intérieur soit à l'extérieur de celui-ci.

11. Dispositif d'éclairage selon la revendication 10, **caractérisé en ce que** la caméra d'observation (12) est réalisée sous forme de caméra CCD ou CMOS.

12. Dispositif d'éclairage selon l'une des revendications précédentes, **caractérisé en ce que** le dispositif de pilotage (5) comprend un écran (52) et des moyens de saisie de données (51).

13. Utilisation d'un dispositif d'éclairage selon l'une des revendications précédentes dans un procédé d'éclairage,
**caractérisée en ce que**
les paramètres de couleur et d'intensité de la lumière émise par les pixels luminescents individuels (11) sont pilotés de telle sorte que des profils bidimensionnels d'évolution de couleurs et/ou des profils bidimensionnels d'intensité de la lumière de projecteurs traditionnels à filament boudiné sont reproduits au moyen des pixels luminescents (11) de l'élément porte-DEL (10).

14. Utilisation d'un dispositif d'éclairage selon la revendication 12 dans un procédé pour éclairer une scène,
**caractérisée par** les étapes de travail suivantes :
- représentation de la scène à éclairer prise par la caméra d'observation (27) sur l'écran (52) du dispositif de pilotage (5),
- imposition de conditions d'éclairage désirées de la scène à éclairer par des moyens de saisie de données (51) du dispositif de pilotage (5),
- détermination et pilotage d'un profil d'évolution de couleurs et d'intensité, correspondant aux conditions d'éclairage désirées, de la lumière émise par l'élément porte-DEL (10) au moyen du dispositif de pilotage (5),
- représentation et évaluation de l'image, prise par la caméra d'observation (27), de la scène éclairée, à l'aide du dispositif de pilotage (5),
- exécution d'une correction du profil bidimensionnel d'évolution de couleurs et d'intensité de la lumière émise par l'élément porte-DEL (10) au moyen du dispositif de pilotage (5) jusqu'à ce que la scène éclairée présente les relations d'éclairage désirées.

15. Utilisation d'un dispositif d'éclairage selon l'une des revendications 1 à 12 dans un procédé pour enregistrer des images d'un mouvement d'au moins un corps devant un arrière-plan, comprenant les étapes suivantes :
- mise à disposition de lumière d'éclairage pour éclairer le corps au moyen du dispositif d'éclairage, et
- enregistrement d'images du mouvement du corps devant l'arrière-plan au moyen d'une caméra,
la caméra étant au repos par rapport à l'arrière-plan pendant l'enregistrement des images,
**caractérisée en ce que**
pendant ou entre l'enregistrement des images, on modifie la température de couleur et/ou l'intensité de la lumière d'éclairage du dispositif d'éclairage (1).

16. Utilisation selon la revendication 15, dans laquelle le mouvement du corps est enregistré pendant un temps d'enregistrement entre un instant initial et un instant final, **caractérisée en ce que** la lumière d'éclairage présente à l'instant initial une température de couleur initiale dans la gamme spectrale violette, à l'instant final une température de couleur finale dans la gamme spectrale rouge, et pendant le temps d'enregistrement une multitude de températures de couleur entre les gammes spectrales rouge et violette du spectre chromatique.

17. Utilisation selon la revendication 15, dans laquelle le mouvement du corps est enregistré pendant un temps d'enregistrement entre un instant initial et un instant final, **caractérisée en ce que** la lumière d'éclairage présente à l'instant initial une température de couleur initiale dans la gamme spectrale rouge, à l'instant final une température de couleur finale dans la gamme spectrale violette, et pendant le temps d'enregistrement une multitude de températures de couleur entre les gammes spectrales rouge et violette du spectre chromatique.

18. Utilisation selon la revendication 16 ou 17, **caractérisée en ce que** la température de couleur de la lumière d'éclairage entre l'instant initial et l'instant final de l'enregistrement des images est modifiée par étape ou en continu depuis la température de couleur initiale vers la température de couleur finale.

19. Utilisation selon la revendication 18, **caractérisée en ce que** la température de couleur de la lumière d'éclairage est modifiée proportionnellement au fur et à mesure du temps d'enregistrement.

20. Utilisation selon l'une des revendications 15 à 19, dans laquelle le corps exécute un mouvement périodique dans le temps et dans l'espace, avec un temps de périodicité T, **caractérisée en ce que** le temps d'enregistrement entre l'instant initial et l'instant final correspond à la moitié du temps de périodicité T/2.

21. Utilisation selon l'une des revendications 15 à 20, **caractérisée en ce que** l'on utilise à titre de caméra une caméra vidéo, une caméra CCD ou une caméra CMOS.

22. Utilisation selon la revendication 21, **caractérisée en ce qu'**une multitude d'images individuelles enregistrées pendant le temps d'enregistrement sont représentées en superposition en une seule image par des moyens de traitement d'image numériques.
